# FASCICULE DE BREVET EUROPEEN

(11) **EP 0 664 564 B1**
(45) Date de publication et mention de la délivrance du brevet: **29.06.2005**
(21) Numéro de dépôt: 95400138.4
(22) Date de dépôt: 23.01.1995
(51) Int. Cl.: H01L 27/02

(54) **Circuit intégré incorporant une protection contre les décharges électrostatistiques**
Integrierte Schaltung, die ein Schutzanordnung gegen elektrostatische Entladungen enthält
Integrated circuit including a protection against electrostatic discharges

(30) Priorité: 25.01.1994 FR 9400784
(43) Date de publication de la demande: 26.07.1995
(73) Titulaire: STMicroelectronics S.A., 92120 Montrouge (FR)
(72) Inventeur: Tailliet, François, F-94230 Cachan (FR)
(74) Mandataire: Bentz, Jean-Paul

(56) Documents cités:
- EP-A- 0 291 242
- EP-A- 0 324 185
- US-A- 5 208 474
- PATENT ABSTRACTS OF JAPAN vol. 14, no. 429 (E-978) 14 Septembre 1990 & JP-A-02 165 664 (MATSUSHITA) 26 Juin 1990
- IEEE TRANSACTIONS ON ELECTRON DEVICES, vol.40, no.11, Novembre 1993, NEW YORK US pages 2081 - 2083, XP000413126 H. TERLETZKI ET AL. 'INFLUENCE OF THE SERIES RESISTANCE OF ON-CHIP POWER SUPPLY BUSES ON INTERNAL DEVICE FAILURE AFTER ESD STRESS'
- PATENT ABSTRACTS OF JAPAN vol. 2, no. 104 (E-53) 26 Août 1978 & JP-A-53 069 589 (MITSUBISHI) 21 Juin 1978
- PATENT ABSTRACTS OF JAPAN vol. 2, no. 112 (E-57) 16 Septembre 1978 & JP-A-53 076 679 (NIPPON DENKI) 7 Juillet 1978

## Description

L'invention concerne les circuits intégrés qui sont sensibles aux risques de dysfonctionnement ou de destruction en présence de décharges électrostatiques, notamment les circuits réalisés en technologie MOS (métal-oxyde-semiconducteur).

Les décharges électrostatiques peuvent se produire parfois tout simplement parce qu'un utilisateur touche les bornes extérieures d'accès à la puce de circuit intégré. Ce risque peut devenir très important dans le cas de circuits intégrés qui sont beaucoup manipulés, et c'est le cas par exemple des circuits incorporés aux cartes à puces : non seulement les cartes à puces sont beaucoup manipulées, mais les contacts d'accès sont directement accessibles sans dispositif mécanique de protection.

Pour protéger les circuits intégrés contre les risques de décharge électrostatique, il est connu notamment de placer sur la puce des dispositifs de protection électronique; disposés chacun à proximité immédiate d'un plot d'accès respectif. Chaque dispositif de protection est relié entre un plot d'accès et un plot de masse (ou plus exceptionnellement entre un plot d'accès et un autre plot d'alimentation). Les plots destinés à recevoir un signal d'entrée sous haute impédance d'entrée sont particulièrement soumis à cette disposition.

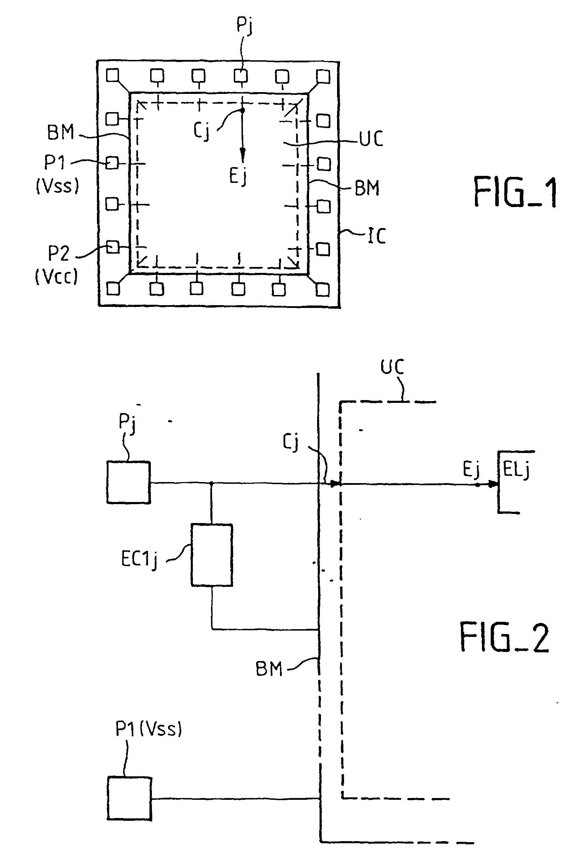

La figure 1 représente la configuration générale d'une puce de circuit intégré, référencée IC, comportant une partie centrale UC dans laquelle se trouve la partie utile de circuit, et une partie périphérique entourant la partie centrale et comportant les plots d'accès permettant de relier le circuit intégré à l'extérieur. Les plots sont en général destinés à recevoir des fils soudés. Chaque plot est relié à la partie utile UC du circuit intégré, pour lui transmettre un signal de tension ou de courant, ou au contraire pour en recevoir un signal. Sur la figure 1, on a désigné par Pj un de ces plots, relié par un conducteur Cj à une entrée Ej de la partie utile du circuit intégré. Dans ce qui suit on désignera par "entrée Ej" un point de circuit quelconque qui doit être relié à un plot Pj, même si fonctionnellement cette "entrée" est en fait une sortie de signal vers l'extérieur plutôt qu'une entrée de signal provenant de l'extérieur. On a désigné par P1 un plot de masse maintenu normalement à un potentiel bas Vss, et par P2 un plot d'alimentation fournissant une tension d'alimentation Vcc. Le plot P1 est en général relié à un bus conducteur BM qui transporte le potentiel de masse tout autour de la puce pour l'amener en divers endroits du circuit qui ont besoin de ce potentiel. Il en est en général de même pour le plot d'alimentation à Vcc. On n'a cependant pas représenté de bus à Vcc pour ne pas alourdir la figure 1.

De manière classique, les dispositifs de protection contre les décharges électrostatiques sont localisés dans la partie périphérique du circuit intégré, à proximité immédiate de chaque plot à protéger.

Le dispositif de protection d'un plot comprend en général un écrêteur de tension, relié entre le plot à protéger et la borne de masse commune; sa fonction principale est de devenir brusquement conducteur lorsque la tension à ses bornes dépasse un seuil déterminé. Il dérive ainsi vers la masse l'énergie de la décharge électrostatique reçue. Cet élément écrêteur a bien sûr une meilleure capacité de résistance à l'énergie reçue que les autres éléments du circuit intégré, et il est de plus conçu pour devenir conducteur avant que les éléments à protéger ne reçoivent une surtension dommageable.

La figure 2 représente la configuration la plus simple généralement utilisée pour protéger un plot Pj relié par un conducteur Cj à une entrée Ej de la partie utile du circuit intégré. L'entrée Ej est un point d'un élément de circuit ELj qui d'une part doit être relié au plot Pj pour le fonctionnement normal du circuit intégré, et d'autre part doit être protégé contre les décharges électrostatiques. L'élément ELj est par exemple simplement un transistor du circuit intégré, et l'entrée Ej peut être la grille de ce transistor, incapable de supporter des tensions trop fortes. Ce pourrait être aussi une source ou un drain de transistor, agissant comme entrée ou sortie de signal dans une communication avec l'extérieur.

A proximité immédiate du plot Pj, et situé dans la zone périphérique du circuit intégré, est placé un écrêteur EC1j. Il est relié entre le plot Pj et le bus de masse BM qui passe à proximité du plot.

Les décharges électrostatiques suffisantes pour déclencher la conduction de l'écrêteur EC1j sont détournées vers le bus de masse BM, empêchant ainsi des surtensions d'apparaître sur le conducteur Cj et donc sur l'entrée Ej. La disposition est la même pour les autres plots à protéger, avec pour chaque plot un écrêteur placé à proximité du plot, relié entre le plot et le bus de masse BM.

L'élément écrêteur peut être une simple diode dont l'anode est reliée au bus de masse et la cathode est reliée au plot à protéger (on suppose, comme c'est presque toujours le cas, que la borne de masse est la borne d'alimentation la plus négative; sinon il faut inverser les connexions).

La diode reste normalement bloquée tant que la tension sur la borne à protéger ne dépasse pas un seuil de mise en avalanche. Si le seuil est dépassé, elle devient conductrice et absorbe le courant de la décharge électrostatique qui l'a rendue conductrice. L'écrêteur peut aussi être un transistor.

On s'est aperçu que ce type de protection ne donnait pas toujours satisfaction, en ce sens que des dysfonctionnements ou destructions pouvaient se produire lorsque des décharges électrostatiques étaient appliquées aux plots à protéger. Un autre circuit intégré est décrit dans EP324125

La présente invention a pour but d'augmenter l'efficacité des dispositifs de protection électrostatiques.

Selon l'invention, on propose de placer un autre écrêteur de tension dans la partie utile du circuit intégré, à proximité immédiate d'un élément de circuit à protéger. Ce deuxième écrêteur n'a pas besoin d'avoir une grande capacité d'écoulement de courant; il peut être beaucoup moins encombrant que le premier, de sorte qu'il peut sans inconvénient majeur être placé à l'intérieur du circuit intégré là où se situe un élément de circuit (grille de transistor d'entrée par exemple) à protéger particulièrement. Sa tension de déclenchement est de préférence sensiblement la même que celle du premier écrêteur et sa valeur est bien sûr choisie en fonction du niveau de tension qu'il est possible d'appliquer sans dommage à l'élément de circuit à protéger.

La présence de ce deuxième écrêteur améliore la protection en limitant les effets de la résistance linéaire du bus de masse, comme on l'expliquera plus loin.

Par conséquent, l'invention telle que revendiquée dans la revendication 1 propose un circuit intégré ayant une partie centrale utile entourée par une partie périphérique, la partie périphérique comportant des plots d'accès reliés respectivement à des éléments de circuit à protéger situés dans la partie centrale utile, avec un dispositif écrêteur de tension situé à proximité de chaque plot dans la partie périphérique et relié entre le plot et un bus de masse commun, et comportant, pour certains plots reliés à un élément de circuit respectif à protéger, un deuxième écrêteur de tension placé dans la partie centrale utile du circuit intégré, à proximité immédiate de l'élément de circuit à protéger, pour limiter les effets de la résistance linéaire du bus de masse.

Un deuxième écrêteur n'est pas nécessaire pour tous les plots, comme on le verra : les éléments de circuit à protéger qui sont géographiquement tout près du plot auxquels ils sont reliés peuvent n'utiliser qu'un seul écrêteur; les éléments qui sont plus loin utilisent selon l'invention un deuxième écrêteur. D'autre part, les éléments de circuit à protéger qui sont reliés à des plots eux-mêmes situés suffisamment près du plot à protéger, peuvent n'utiliser qu'un seul écrêteur situé dans la partie périphérique.

De préférence, une résistance est intercalée entre un plot respectif et l'élément de circuit correspondant à ce plot et devant être protégé. Elle limite le courant dirigé vers cet élément et introduit une chute de tension entre le plot et le deuxième écrêteur dès qu'un courant circule dans le deuxième écrêteur.

D'autres caractéristiques et avantages de l'invention apparaîtront à la lecture de la description détaillée qui suit et qui est faite en référence aux dessins annexés dans lesquels :
- la figure 1, déjà décrite, représente la configuration générale d'un circuit intégré;
- la figure 2 représente la disposition classique d'un écrêteur de protection à proximité d'un plot;
- la figure 3 représente la configuration de dispositif de protection adoptée dans un circuit intégré selon l'invention.

En étudiant ce qui se passe au cours d'une décharge électrostatique dans le dispositif de protection de la figure 2, on s'est rendu compte que lorsque le courant de décharge dérivé par l'écrêteur de tension EC1j est important, il crée une chute de tension importante dans le bus de masse BM entre le plot Pj à protéger et le plot de masse P1.

En effet, la décharge électrostatique sur le plot Pj provoque la mise en conduction de l'écrêteur EC1j, dérivant le courant de décharge vers le bus de masse BM et de là vers le plot de masse P1. Le bus de masse est un conducteur d'aluminium déposé sur le circuit intégré, et dont la résistance linéaire n'est pas nulle. La largeur du bus est en effet limitée par des considérations d'encombrement; elle peut atteindre une vingtaine de micromètres mais guère plus; l'épaisseur du bus est définie par la technologie pour tous les conducteurs du circuit et est de l'ordre de un micromètre.

La résistance du bus de masse, bien que faible, introduit une chute de tension d'autant plus importante que le plot P1 est plus éloigné du plot Pj correspondant à l'entrée de circuit Ej à protéger. La longueur de bus BM parcourue par le courant de décharge peut être de plusieurs millimètres.

Il en résulte alors que la différence de potentiel entre le plot Pj et le plot de masse P1 qui évacue le courant de décharge n'est pas la tension VM imposée par l'écrêteur EC1j mais c'est la somme de la tension VM et de la chute de tension RI dans la portion de bus BM située entre les plots Pj et P1. Cette chute de tension peut être de plusieurs volts ou même plusieurs dizaines de volts dans le cas de décharges fortes. L'entrée Ej à l'intérieur du circuit intégré est alors soumise à un potentiel essentiellement égal à cette somme, et ce potentiel peut dans certains cas être beaucoup trop élevé.

C'est pourquoi on propose selon l'invention de placer un deuxième écrêteur à proximité de l'entrée Ej à protéger, donc dans la partie utile UC du circuit intégré.

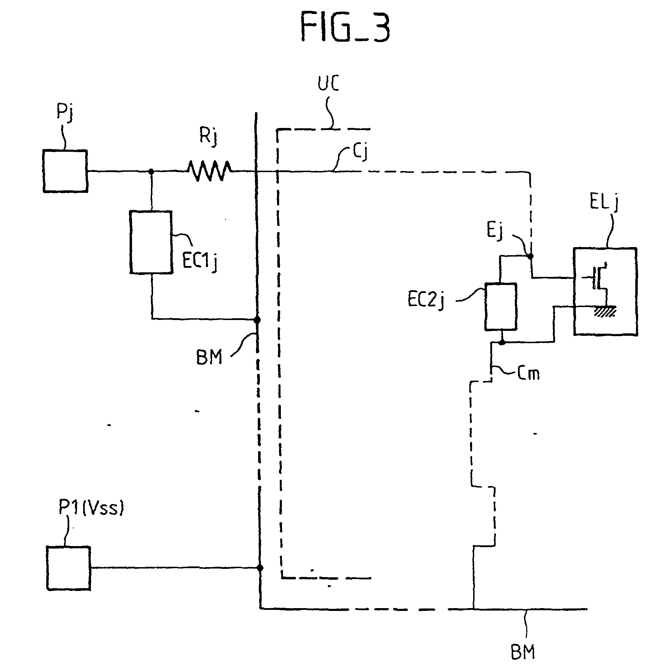

La figure 3 représente une disposition selon l'invention, appliquée à la protection d'une entrée Ej reliée à un plot Pj. L'élément de circuit ELj dont l'entrée Ej est à protéger, est, là encore, situé dans la partie utile UC du circuit intégré; il est éloigné du plot Pj et lui est relié par le conducteur Cj et, comme on le verra plus loin, par une résistance Rj.

L'entrée Ej est encore protégée par un écrêteur EC1j identique à celui qui a été décrit à propos de la figure 2. Cet écrêteur est placé dans la partie périphérique du circuit intégré, entre le plot Pj et le bus de masse BM.

Un deuxième écrêteur EC2j est au contraire situé dans la partie utile UC, et il est placé de préférence à proximité immédiate de l'élément de circuit ELj à protéger. Il est relié d'une part à l'entrée Ej et d'autre part à un conducteur Cm relié au bus de masse BM.

Une résistance Rj est placée en série avec le conducteur Cj, entre le plot Pj et l'entrée Ej de l'élément de circuit ELj. Sa valeur peut être de quelques centaines à quelques milliers d'ohms. Sa valeur supérieure est limitée vers le haut seulement dans le cas où l'impédance d'entrée de l'élément ELj est faible. Dans ce cas en effet, la résistance Rj introduit une chute de tension en fonctionnement normal et on doit limiter cette chute de tension pour que le fonctionnement reste acceptable. Mais si l'entrée Ej est une grille de transistor à effet de champ ou un autre élément à grande impédance d'entrée, la valeur de la résistance Rj n'est pas critique; elle sera choisie suffisamment élevée pour limiter le courant dans le second écrêteur EC2j à une valeur acceptable (qui dépend des dimensions de l'écrêteur EC2j).

Le dispositif de protection selon l'invention fonctionne de la manière suivante : lorsqu'une décharge électrostatique atteint le plot d'accès Pj, le premier écrêteur EC1j devient conducteur et reçoit la majeure partie du courant de la décharge. La résistance du bus de masse peut être de l'ordre de 50 milliohms par carré. Pour un bus de masse BM de 20 micromètres de large ayant une longueur de 2 millimètres entre le plot Pj et le plot de masse P1, cela correspond à 100 carrés de longueur soit une résistance de 5 ohms environ. Si le courant de décharge est de quelques ampères, une chute de tension de plusieurs volts (par exemple une vingtaine de volts pour un courant de 4 ampères) peut se produire dans le bus de masse BM entre le plot P1 et le plot Pj.

Cette chute de tension s'ajoute à la tension aux bornes du premier écrêteur pour établir une différence de potentiel entre l'entrée Ej et le potentiel de masse. Cette tension serait trop élevée et risquerait d'entraîner la destruction du circuit intégré. Mais cette somme de tensions est également reportée aux bornes du deuxième écrêteur EC2j, par l'intermédiaire des conducteurs Cj et Cm. Le deuxième écrêteur devient conducteur avant que cette somme de tensions ne devienne critique. C'est ce qui se passe notamment dans le cas où la tension de seuil de conduction du deuxième écrêteur est la même que celle du premier écrêteur, mais également dans le cas où elle est un peu plus élevée. L'énergie de la décharge du deuxième écrêteur (qui est une fraction de l'énergie totale de la décharge électrostatique) est alors dérivée vers le conducteur de masse Cm. L'élément de circuit ELj est donc protégé. Le courant consommé par la mise en conduction du deuxième écrêteur est limité par la résistance Rj. Le deuxième écrêteur peut donc avoir une taille limitée. Le courant principal de la décharge reste évacué vers le plot de masse P1 par le premier écrêteur mais l'effet néfaste de la résistance du bus de masse est largement éliminé.

Bien qu'il eût été possible de prévoir un seul écrêteur, qui serait le deuxième écrêteur, localisé dans la partie utile UC du circuit intégré, on préfère prévoir qu'un écrêteur principal (celui qui est capable d'évacuer la majeure partie du courant de décharge) reste dans la partie périphérique du circuit, le deuxième écrêteur n'ayant qu'une fonction auxiliaire. En effet, il est préférable de confiner les zones de fort courant ou de forte tension hors de la partie active du circuit. Cela améliore la tenue du circuit contre les déclenchements intempestifs de thyristors parasites présents dans le circuit intégré. Cela évite aussi que les porteurs de charge rayonnés par l'écrêteur au cours de la décharge viennent abîmer la logique interne (détérioration de transistors, programmation parasite de points mémoire, etc.). Si le premier écrêteur n'existait pas, tout le courant de décharge circulerait en plein milieu de la partie utile du circuit intégré. Il faudrait alors tirer vers l'intérieur du circuit des lignes de métal reliées au plot de masse P1, ces lignes étant suffisamment larges pour résister à des courants de plusieurs ampères, ce qui est très encombrant.

La tension d'écrêtage du premier écrêteur est de préférence comprise entre 10 volts et 20 volts. Le choix de cette tension est fait pour que la puissance dissipée dans cet écrêteur soit suffisamment faible. C'est le second écrêteur, placé après la résistance Rj, qui fixe la tension de décharge résiduelle présente à l'intérieur de la partie utile du circuit intégré. Une tension de décharge de 15 volts est en général convenable pour des circuits intégrés classiques de technologie CMOS sur silicium.

La résistance Rj est de préférence réalisée par une diffusion de type N+ dans un substrat de type P. Elle limite le courant dans le deuxième écrêteur et peut avoir une valeur de quelques kilohms. Le courant sera limité à quelques milliampères ou quelques dizaines de milliampères au maximum, ce qui permet de réaliser un écrêteur EC2j peu encombrant.

L'écrêteur EC2j, comme l'écrêteur EC1j, peut être réalisé par une diode susceptible de passer en avalanche en cas de surtension, ou encore par un transistor ou même un thyristor.

## Revendications

1. Circuit intégré ayant une partie centrale utile (UC) entourée par une partie périphérique, la partie périphérique comportant un plot de masse (P1), un bus de masse commune (BM) relié au plot de masse (P1) et entourant la partie centrale utile (UC), des plots d'accès (Pj) reliés respectivement à des noeuds d'entrée/sortie d'éléments de circuit à protéger (Elj) situés dans la partie centrale utile, et un dispositif écrêteur de tension (EC1j) situé à proximité de chaque plot d'accès dans la partie périphérique et reliant ce plot d'accès audit bus de masse commune (BM), et comportant, pour certains plots d'accès dont chacun est relié à un élément de circuit respectif à protéger, un deuxième écrêteur de tension (EC2j) placé dans la partie centrale utile du circuit intégré, à proximité immédiate de l'élément de circuit à protéger (Elj), ce deuxième écrêteur étant connecté entre le noeud d'entrée/sortie (Ej) dudit élément de circuit à protéger et un conducteur (Cm) reliant ledit élément de circuit à protéger (Elj) au bus de masse commune (BM), pour limiter les effets de la résistance linéaire dudit bus de masse commune.

2. Circuit intégré selon la revendication 1, **caractérisé en ce qu'**une résistance (Rj) est intercalée entre un plot respectif (Pj) et l'élément de circuit correspondant à protéger (Elj).

## Patentansprüche

1. Integrierte Schaltung mit einem zentralen Nutzbereich (UC), der von einem Umgebungsbereich umgeben ist, wobei der Umgebungsbereich einen Masseanschluss (P1), einen gemeinsamen Massebus (BM), der mit dem Masseanschluss (P1) verbunden ist und den zentralen Nutzbereich (UC) umgibt, Zugangsanschlüsse (Pj), die jeweils mit in dem zentralen Nutzbereich angeordneten Eingangs-/Ausgangsknotenpunkten der zu schützenden Schaltelemente (Elj) verbunden sind, und eine Spannungsbegrenzungsvorrichtung (EC1j) umfasst, die in Nähe zu jedem Zugangsanschluss in dem Umgebungsbereich angeordnet ist, und die diesen Zugangsanschluss mit dem gemeinsamen Massebus (BM verbindet, und mit einem zweiten, in dem zentralen Nutzbereich der integrierten Schaltung, in unmittelbarer Nähe zu dem zu schützenden Schaltelement (Elj) angeordneten Spannungsbegrenzer (EC2j) für bestimmte Zugangsanschlüsse, von denen jeder mit einem jeweiligen zu schützenden Schaltelement verbunden ist, wobei dieser zweite Begrenzer zwischen dem Eingangs-/Ausgangsknotenpunkt (Ej) des zu schützenden Schaltelementes und einem Leiter (Cm) angeschlossen ist, der das zu schützende Schaltelement (Elj) mit dem gemeinsamen Massebus (BM) verbindet, um die Auswirkungen des linearen Widerstandes des gemeinsamen Massebusses zu begrenzen.

2. Integrierte Schaltung gemäß Anspruch 1, **dadurch gekennzeichnet, dass** ein Widerstand (Rj) zwischen einem jeweiligen Anschluss (Pj) und dem entsprechenden zu schützenden Schaltelement (Elj) angeordnet ist.

## Claims

1. An integrated circuit having a useful central portion (UC) surrounded by a peripheral portion, the peripheral portion including an earth contact (P1), a common earth bus (BM) which is linked to the earth contact (P1) and surrounds the useful central portion (UC), access contacts (Pj) which are linked respectively to input/output nodes of circuit elements to be protected (Elj) located in the useful central portion, and a voltage-limiting device (EC1j) located close to each access contact in the peripheral portion and linking this access contact to said common earth bus (BM), and including, for certain access contacts each of which is linked to a respective circuit element to be protected, a second voltage limiter (EC2j) placed in the useful central portion of the integrated circuit, in the immediate vicinity of the circuit element to be protected (Elj), this second limiter being connected between the input/output node (Ej) of said circuit element to be protected and a conductor (Cm) linking said circuit element to be protected (Elj) to the common earth bus (BM), for limiting the effects of the linear resistance of said common earth bus.

2. An integrated circuit according to Claim 1, **characterized in that** a resistance (Rj) is inserted between a respective contact (Pj) and the corresponding circuit element to be protected (Elj).
